# Europäisches Patentamt

## European Patent Office

## Office européen des brevets

(19)

(11) Publication number: **0 103 085**
**B1**

(12) ## EUROPEAN PATENT SPECIFICATION

(45) Date of publication of patent specification: **15.10.86**

(51) Int. Cl.⁴: **H 01 L 21/302**

(21) Application number: **83106147.8**

(22) Date of filing: **23.06.83**

(54) A method for polishing semiconductor wafers with montmorillonite slurry.

(30) Priority: **12.08.82 US 407403**

(43) Date of publication of application:
**21.03.84 Bulletin 84/12**

(45) Publication of the grant of the patent:
**15.10.86 Bulletin 86/42**

(84) Designated Contracting States:
**DE FR GB**

(56) References cited:
**CH-A- 505 466**
**DE-C-1 227 307**
**FR-A-2 414 387**
**US-A-3 966 432**
**US-A-4 057 939**

(73) Proprietor: **International Business Machines
Corporation
Old Orchard Road
Armonk, N.Y. 10504 (US)**

(72) Inventor: **Basi, Jagtar Singh
97 Nantucket Drive
Fishkill New York 12524 (US)**
Inventor: **Mendel, Eric
3 High Point Drive
Poughkeepsie New York 12603 (US)**

(74) Representative: **Suringar, Willem Joachim
Intellectual Property Department IBM Nederland
N.V. Watsonweg 2
NL-1423 ND Uithoorn (NL)**

Courier Press, Leamington Spa, England.

## Description

Technical field

This invention relates to the polishing of the surfaces of semiconductor wafers. In the production of semiconductor devices, polished silicon wafers free of undesirable crystal defects and surface imperfections are a basic requirement. In a typical process for fabricating semiconductor devices, the surfaces of the wafers are polished and cleaned at the last step in the process of preparing the wafers.

Background art

In the prior art, semiconductor wafers, particularly silicon wafers, have been polished by silica based slurries using many different types of polishing machines. Although a number of improvements have been made to the silica based slurry, there has been no substitute to colloidal silicon dioxide for achieving an acceptable degree of perfection.

A typical abrasive slurry for polishing silicon wafers is taught in U.S. Patent No. 4,057,939; the slurry comprises colloidal $SiO_2$ admixed with $Na_2CO_3$ and an oxidizing agent such as sodium dichloroisocyanurate. It is believed that the polishing mechanism is due to the rapid oxidation of silicon to $SiO_2$ by the polishing slurry component, followed by softening of $SiO_2$ thus formed to give silica gel ($Si(OH)_4$) which, in turn, further absorbs the slurry components and becomes softer and is easily removed by the scrubbing action of the polishing slurry. Thus, the polishing mechanism is chemical-mechanical.

Polishing may be effected in machines such as described in U.S. Patent No. 3,691,694 including modifications thereof in accordance with the planetary configuration shown in IBM Technical Disclosure Bulletin, pp. 1760—1761, Vol. 15, No. 6, November 1972.

It is also known that montmorillonite minerals have been mined in a large volume and have been used as a binder for sand in foundry molds and as a thickener for oil-well drilling muds. "The Colloid Chemistry of Silica and Silicates" by R. G. Iler, pp. 190—199, Cornell University Press, 1955 describes the chemical structure and nature of montmorillonite minerals.

U.S. Patent 3,966,432 entitled "Liquid Abrasive Compositions Containing a Silicate Suspending Agent" teaches that natural and synthetic clays including hydrophobically treated montmorillonite can be used as a suspending agent for abrasive material for cleaning hard surfaces of such materials as stainless steel, ceramics and vitreous enamel. The abrasive materials listed are calcite (ground marble), silica, felspar, pumice, kieselguhr and labradorite.

U.S. Patent 4,169,796 teaches that sodium montmorillonite clay when it is mixed with dicalcium phosphate and distilled demineralized water creates an effective and useful shaving lotion and a product for polishing and cleaning dentures.

Nonetheless, there has been no attempt in the known prior art to utilize montmorillonite clay in the manufacture of semiconductor devices, particularly for polishing semiconductor wafers.

Disclosure of invention

It is an object of the present invention to provide a new slurry composition for polishing semiconductor wafers.

It is another object of the invention to provide a substitute for silica based slurries.

It is a further object of the invention to provide a polishing agent for semiconductor wafers which does not degrade polishing pads.

It is still another object of the invention to provide a relatively inexpensive polishing slurry for semiconductor wafers.

There are two approaches that are generally used to polish silicon wafers. The first approach involves a two step process. Step one of the two-step process entails the use of a highly applied pressure to the workpiece for rapid stock removal. Step two is done at low pressures for a short time and is done primarily for cosmetic purposes, though in some instances, it may also be used to remove superficial surface damage.

The second approach is a single step process performed at low pressure and longer times. This approach can be applied to a single-sided or simultaneous two-sided free polishing.

Low applied pressure generally means that the applied load on the workpiece is less than 69 kPa (10 psi). High pressure polishing means that an applied load is in excess of that amount and as high as 552 kPa (80 psi). The slurry of the present invention can be used in all variations of polishing, with different types of high and low pressure polishing machines and with all types of polishing pads.

In accordance with the present invention as claimed, the polishing slurry comprises montmorillonite, deionized water and an alkali such as sodium hydroxide or potassium hydroxide. The polishing slurry is prepared by slowly adding two to ten percent by weight of montmorillonite powder to deionized water with continuous stirring to form a colloidal suspension. The pH of the suspension is then adjusted to a value in the range of 9.5—12.5 by monitored addition of sodium or potassium hydroxide solution.

In the polishing operation, NaOH or KOH reacts with silicon to form $Na_2SiO_3$ or $K_2SiO_3$ which is mechanically removed by montmorillonite. With a value of pH higher than 12.5, the silicon surface tends to be excessively etched, which makes it difficult to achieve a smooth and flat surface. When pH is lower than 9.5, effective polishing is hard to achieve because of the low level of chemical reaction.

2

Since an oxidizing agent such as NaOCl need not be included in the polishing slurry of the invention, the problem of oxidizing agent induced pad degradation is eliminated. The present invention provides a second source for semiconductor polishing slurry, which is much less expensive than the conventional silica based slurry.

Best mode for carrying out the invention

Montmorillonite clay which is available under the trade name of Gelwhite (Trademark) from Georgia Kaolin Co., is added slowly to deionized water to form a colloidal suspension. The pH of the suspension is adjusted to the value of 11.5 for low pressure polishing and to 12.0 for high pressure polishing. Silicon wafers having a diameter of 82.5 mm are polished with the slurry utilizing a free polisher which is substantially described in the aforementioned U.S. Patent 3,691,694.

The free polisher comprises a rotatable platen having a polishing cloth on the upper surface upon which a mask having suitable apertures therein for receiving wafers is positioned. A hoop is connected to the mask for imparting rotation thereof separately from the rotation of the platen. Overlying the mask and wafers is an upper plate having a polishing cloth thereon for applying a uniform pressure upon the opposite surface of the wafer. The upper plate is separately driven so that upon rotation of the platen, with the hoop and the mask, and the upper plate the opposite planar surfaces of the wafer are brought into coplanarity while being polished.

In the polishing operation, a polishing slurry is provided on the polishing cloth at the central portion of the platen by a feed system. As the upper plate turns within the hoop, radially extending grooves in the plate catch excess slurry and due to the centrifugal force caused by rotation of the plate they tent to move the slurry outwardly. In this manner excess polishing slurry is removed from the platen and caught in a suitable container for reprocessing and reuse if desired. During polishing, wheel speeds may vary from 40 rpm to 60 rpm, optimum at 55 rpm.

Tables I and II show the conditions used in low pressure polishing and high pressure polishing respectively.

TABLE I

| Pressure (kPa) | (psi) | pH | Slurry flow rate (cc/min.) | Temp. (°C) | Removal rate (μm/min.) |
|---|---|---|---|---|---|
| 17.9 | 2.6 | 11.5 | 500 | 54 | 0.8 |
| 31.1 | 4.5 | 11.5 | 500 | 42 | 0.5 |
| 36.6 | 5.3 | 11.5 | 500 | 42 | 0.8 |

TABLE II

| Pressure (kPa) | (psi) | pH | Slurry flow rate (cc/min.) | Temp. (°C) | Removal rate (μm/min.) |
|---|---|---|---|---|---|
| 255 | 37 | 12.0 | 300 | 40—90 | 5.1 |
| 552 | 80 | 12.0 | 300 | 40—90 | 8.5 |

The stock removal rates accomplished with this slurry are comparable to the removal rates achieved with the silica based slurry which includes an oxidizing agent such as NaOCl, as disclosed in the aforementioned U.S. Patent 4,057,939. Such oxidizing agent is known to degrade the polishing cloth. Typically the life of the polishing cloth is reduced to one-half when it is subjected to an oxidizing agent.

The slurry flow rate can be any rate in the range of 300 to 500 cc/min. When it is lower than 300 cc/min., the friction between the polishing cloth and the wafers becomes excessive and renders it difficult to run the polisher. A flow rate larger than 500 cc/min, is simply not necessary and it is wasteful.

In the high pressure polishing, the polishing temperature is determined by the friction between the polishing cloth and the wafers, and it can vary from 40 to 90°C.

The mechanism of stock removal is more mechanical in the high pressure polishing so that the applied pressure is the predominant factor for controlling stock removal rates. It should be noted that with low pressure polishing, stock removal rates typically are most sensitive to pressure and temperature variations.

After polishing and removal from the polishing ambient, the wafer surfaces are readily cleanable. One singular effect is that the addition of NaOCl (sodium hypochlorite) at an appropriate time near the end of the polishing cycle results in a hydrophilic surface after polishing. This ability to render surfaces hydrophilic, characteristic of hypophalites, facilitates post polish wafer cleaning. Although an 82.5 mm wafer was used to demonstrate the invention, any size wafer can be polished with the polishing slurry of the invention.

3

**0 103 085**

## Claims

1. A method for polishing a semiconductor wafer comprising:
preparing a polishing slurry by dispersing an abrasive powder in water, and
polishing the wafer with said slurry,
characterized by:
selecting montmorillonite clay as the abrasive powder, dispersing it in deionized water, and using this as polishing slurry.

2. The method of claim 1 wherein alkali is included in the slurry such that the pH of the slurry is in the range of 9.5 to 12.5.

3. The method of claim 2 comprising:
adding montmorillonite powder to deionized water with continuous stirring to form a colloidal suspension, and
adding alkali solution to said suspension to adjust the pH in the range of 9.5 to 12.5.

4. The method of claim 3 wherein 2 to 10 percent by weight of montmorillonite powder is added to said deionized water.

5. The method of claim 2, 3 or 4 wherein said alkali is sodium or potassium hydroxide.

6. The method of any previous claim wherein polishing is done under a low pressure of less than 69 kPa (10 psi) applied to said wafer.

7. The method of any of claims 1—5 wherein polishing is done under a high pressure of 207 to 552 kPa (30 to 80 psi) applied to said wafer.

8. The method of any previous claim wherein sodium hypochlorite is added to the slurry at a time near the end of the polishing cycle.

9. A composition for polishing semiconductor substrates comprising 2 to 10 percent by weight of montmorillonite clay as the sole abrasive constituent, added to deionized water, and alkali sufficient to render a pH value in the range of 9.5 to 12.5.

10. The composition of claim 9 wherein said alkali is sodium or potassium hydroxide.

## Patentansprüche

1. Verfahren zum Polieren einer Halbleiter-Wafer, welches
das Herstellen eines Polierschlamms durch Dispergieren eines Schleifpulvers in Wasser und
das Polieren der Wafer mit dem Schlamme umfaßt,
gekennzeichnet durch
das Auswählen von Montmorillonit-Ton als Schleifpulver, Dispergieren desselben in entionisiertem Wasser und Verwenden dessen als Polierschlamm.

2. Verfahren nach Anspruch 1, bei welchem Alkali in dem Schlamme so enthalten ist, daß der pH-Wert des Schlamms im Bereich von 9,5 bis 12,5 liegt.

3. Verfahren nach Anspruch 2, welches
das Zusetzen von Montmorillonit-Pulver zu entionisiertem Wasser unter kontinuierlichem Rühren zur Ausbildung einer kolloidalen Suspension und
das Zusetzen von Alkali-Lösung zur Suspension zur Einstellung des pH-Werts im Bereich von 9,5 bis 12,5 umfaßt.

4. Verfahren nach Anspruch 3, bei welchem 2 bis 10 Gewichtsprozent Montmorillonit-Pulver dem entionisierten Wasser zugesetzt werden.

5. Verfahren nach Anspruch 2, 3 oder 4, bei welchem das Alkali Natrium- oder Kaliumhydroxid ist.

6. Verfahren nach irgendeinem vorstehenden Anspruch, bei welchem das Polieren bei einem auf die Wafer ausgeübten niedrigen Druck von weniger als 69 kPa (10 psi) durchgeführt wird.

7. Verfahren nach irgendeinem der Ansprüche 1 bis 5, bei welchem das Polieren bei einem auf die Wafer ausgeübten hohen Druck von 207 bis 552 kPa (30 bis 80 psi) durchgeführt wird.

8. Verfahren nach irgendeinem vorstehenden Anspruch, bei welchem Natriumhypochlorit dem Schlamme zu einem Zeitpunkt gegen Ende des Polierganges zugesetzt wird.

9. Zusammensetzung zum Polieren von Halbleitersubstraten, welche 2 bis 10 Gewichtsprozent Montmorillonit-Ton als einzigen Schleifbestandteil, zugesetzt zu entionisiertem Wasser, und Alkali, ausreichend zur Erzielung eines pH-Werts im Bereich von 9,5 bis 12,5, umfaßt.

10. Zusammensetzung nach anspruch 9, bei welcher das Alkali Natrium- oder Kaliumhydroxid ist.

## Revendications

1. Un procédé pour le polissage d'une plaque de semi-conducteur comprenant la préparation d'une suspension de polissage par dispersion
d'une poudre abrasive dans l'eau et le polissage de la plaque avec ladite suspension,
caractérisé par:
le choix d'une argile de type montmorillonite comme poudre abrasive, sa dispersion dans de l'eau désionisée et son emploi comme suspension de polissage.

2. Le procédé de la revendication 1 dans lequel un alcali est incorporé à la suspension pour que le pH de la suspension soit dans la gamme de 9,5 à 12,5.

3. Le procédé de la revendication 2 comprenant:

l'addition de poudre de montmorillonite à de l'eau désionisée avec agitation continue pour former une suspension colloïdale, et

l'addition d'une solution d'alcali à ladite suspension pour ajuster le pH dans la gamme de 9,5 à 12,5.

4. Le procédé de la revendication 3, dans lequel on ajoute 2 à 10 % en poids de poudre de montmorillonite à ladite eau désionisée.

5. Le procédé de la revendication 2, 3 ou 4 dans lequel ledit alcali est l'hydroxyde de sodium ou de potassium.

6. Le procédé de l'une quelconque des revendications précédentes dans lequel le polissage est effectué sous une pression faible inférieure à 69 kPa (10 psi) appliquée à ladite plaque.

7. Le procédé de l'une quelconque des revendications 1—5 dans lequel le polissage est effectué sous une pression élevée de 207 à 552 kPa (30 à 80 psi) appliquée à ladite plaque.

8. Le procédé de l'une quelconque des revendications précédentes dans lequel de l'hypochloride de sodium est ajouté à la suspension en un moment proche de la fin du cycle de polissage.

9. Une composition pour le polissage des substrats de semi-conducteur comprenant 2 à 10 % en poids d'argile de type montmorillonite, comme seul constituant abrasif ajouté à de l'eau désionisée, et un alcali suffisant pour porter la valeur du pH dans la gamme de 9,5 à 12,5.

10. La composition de la revendication 9 dans laquelle ledit alcali est l'hydroxyde de sodium ou de potassium.